# EUROPEAN PATENT APPLICATION

(11) **EP 4 354 484 A1**
(43) Date of publication of application: **17.04.2024**
(21) Application number: 23202626.0
(22) Date of filing: 10.10.2023
(51) Int. Cl.: H01J 37/10, H01J 37/141, H01J 37/28

(54) **REDUCTION OF POWER COMSUMPTION FOR A CHARGED PARTICLE SYSTEM**

(30) Priority: 10.10.2022 EP 22200647
(71) Applicant: FEI COMPANY, Hillsboro, OR 97124 (US)
(72) Inventor: van Rooij, Corné, 5651 GG Eindhoven (NL); Bischoff, Maarten, 5401 BW Uden (NL); McCormack, Jamie, 5645 KM Eindhoven (NL); Smit, Casper, 5583XS Waalre (NL); Veerhoek, Marcel, 5663 PW Geldrop (NL)
(74) Representative: Stellbrink & Partner Patentanwälte mbB

(57) **Abstract**

The present invention relates to a method for reducing the power consumption of a charged particle system, the charged particle system comprising at least one charged particle optics element and a cooling assembly configured for cooling the at least one charged particle optics element, the method comprising the steps of running the charged particle system in a standby mode, wherein the total power consumption of the charged particle system is reduced compared to running the charged particle system in an operating mode. Furthermore, the present invention relates to a respective charged particle system.

## Description

### Field

The present invention generally relates to the field of charged particle optics, particularly electromagnetic lenses for example used in charged particle beam microscopy systems. More specifically, the present invention relates to a method for reducing the power consumption of a charged particle system and a respective charged particle system.

### Background

Charged particle beam microscopy systems are widely used for precise observation, characterization, and/or fabrication of micro- or nano-scale systems, e.g., samples. Due to the use of charged particles, these systems can advantageously provide a higher resolution than conventional optical microscopy systems which rely on using light. In fact, charged particle beam microscopy systems routinely allow resolutions ranging from tens of pm to hundreds of nm. Such a system may for example be an electron beam microscope or an ion beam microscope.

Similar to conventional optical microscopy systems, charged particle beam microscopy systems require charged particle optics, particularly lenses, for manipulating (e.g., focusing) the charged particle beam. Such charged particle optics are generally based on electric and magnetic fields acting on the charged particles, similar to optical media acting on a light beam. In charged particle beam microscopy systems, the charged particle optics may particularly comprise electromagnetic lenses.

In particular electromagnetic lenses may comprise at least one electromagnetic coil also referred to as electromagnet or simply coil. These systems require currents on the order of a few amperes, e.g., in the range of 1-20 A, which, owing to the wire resistance, also introduce significant heat to the system. Therefore, charged particle optics may induce thermal drifts due to thermal expansion and contraction of different components of the system. Thus, active cooling is typically provided to thermally stabilize the system and avoid thermal drifts and also to prevent damage to coils and/or to other elements by overheating.

However, it takes significant time for a system at room temperature utilizing charged particle optics to stabilize after turning on the system and particularly the charged particle optics. That is, it can take many hours after turning a system on before it is stable. Furthermore, drifts of the system occurring during the start-up time in which the system stabilizes result in previously made alignments no longer matching the system state. Overall, this means that the system is not usable for the user. Therefore, current charged particle beam microscopy systems are typically run 24 hours, 7 days a week to guarantee temperature stability and performance. In other words, it is currently standard for such systems to be turned on 24/7 to guarantee performance availability as it is not practical to turn them off.

However, a significant portion of the power usage in a charged particle system utilizing charged particle optics, e.g., in a charged particle beam microscopy system such as a transmission electron microscope (TEM), can be attributed to the optics system and cooling of said optics system in order to maintain temperature stability and performance. In other words, temperature stability and performance come at a cost of high power consumption even when the system is not currently used, i.e., when the system is in an idle mode. In addition, increasing performance demands generally leads to increased optics power and/or temperature stability demands both of which impact the optics power and cooling. Similarly the introduction of full constant power in certain charged particle systems can increase the power usage of charged particle optics when the system is idle. In this regard, full constant power may refer to driving charged particle optics elements, e.g., multiple coils of charged particle optics elements, such that the power dissipation is constant independent of the nett focussing power of said charged particle optics elements up to the maximum acceleration voltage of the respective charged particle system, wherein the maximum acceleration voltage may for example be one of 120 kV, 200 kV, 300 kV or 400 kV.

There is a general need to reduce power consumption in order to save energy, reduce greenhouse gas equivalents, comply with regulations, and/or cut costs. However, due to the reasons provided above, simply turning off optics (or the whole system) when not in use is not acceptable to save power. It simply is not practical and may render the system unusable.

In light of the above, it is an object to overcome or at least alleviate the shortcomings and disadvantages of the prior art. That is, it is an object of the present invention to provide a method and system for reducing the power consumption of a system comprising charged particle optics when in a standby mode.

These objects are met by the present invention.

### Summary

In a first embodiment, the present invention relates to a method for reducing the power consumption of a charged particle system, the charged particle system comprising at least one charged particle optics element and a cooling assembly configured for cooling the at least one charged particle optics element, the method comprising the steps of running the charged particle system in a standby mode, wherein the total power consumption of the charged particle system is reduced compared to running the charged particle system in an operating mode. That is, the present method provides a standby mode for the charged particle system, wherein the total power consumption is reduced compared to a normal operating mode, such that advantageously power/energy can be saved when the system is idle, e.g., during nighttime and/or on weekends. In addition to saving power, another major benefit to users may be that this method combines power saving with minimizing the thermal stabilization time when switching between standby and operating mode.

Each of the at least one charged particle optics element may comprise a respective element temperature, wherein the method may further comprise determining a respective temperature setpoint for at least one of the at least one charged particle optics element, and wherein running the charged particle system in the standby mode may comprise reducing and/or stopping the cooling of said at least one charged particle optics element and stabilizing the respective element temperature of said at least one charged particle optics element to the respective temperature setpoint. It will be understood that "said at least one charged particle optics element" is to be understood as "the at least one of the at least one charged particle optics element". In other words, when running the system in standby mode, cooling of at least one of the at least one charged particle optics element is at least reduced, preferably stopped, while the temperature of said at least one charged particle optics element is stabilized to the respective temperature setpoint. This may advantageously allow to reduce the power consumption through the cooling assembly and the at least one of the at least one charged particle optics element while ideally maintaining its temperature to reduce and/or avoid thermal drifts of the system. In turn this may further advantageously allow for a shorter period of time for reaching thermal stabilization after switching from standby mode to operating mode. The temperature of the at least one of the at least one charged particle optics element may preferably be stabilized via a current provided to said element, which may be significantly lower compared to the current provided during normal operation and with cooling.

Further, in some embodiments the method may comprise determining a respective temperature setpoint for each of the at least one charged particle optics element, reducing and/or stopping the cooling of each of the at least one charged particle optics element, and stabilizing the respective element temperature of each of the at least one charged particle optics element to the respective temperature setpoint. That is, preferably, the cooling is reduced for all of the at least one charged particle optics element and the respective element temperature is stabilized to the respectively determined temperature setpoint.

It will be understood, that stabilizing the respective element temperature to a respective temperature setpoint may generally allow for certain deviations from the temperature setpoint, e.g., within measurement errors. Particularly, the element temperature may be maintained for the associated charged particle optics element such that the system performance is sufficiently stable for a desired application. Specifically, stabilizing the respective element temperature may comprise maintaining the respective element temperature of the associated charged particle optics element within 90% to 110%, preferably within 95% to 105%, more preferably within 99% to 101% of the respective temperature setpoint, i.e., the respective element temperature of each of the at least one charged particle optics element for which the element temperature is stabilized may be maintained accordingly.

Reducing and/or stopping the cooling of said or each of the at least one charged particle optics element may comprise reducing and/or stopping a flow of cooling fluid to said or each of the at least one charged particle optics element, respectively. That is the cooling assembly, e.g., a chiller, may be fluid based. The cooling fluid may be water. Generally, the cooling assembly may be configured for cooling other elements of the charged particle system.

Running the charged particle system in the standby mode may comprise turning the cooling assembly off. Turning the cooling assembly off may comprise turning all elements of the system that are cooled by the cooling assembly off or placing them in a respective element-specific standby mode. In other words, in some embodiments the cooling assembly may be completely turned off when running the system in standby mode. This may be advantageous as it may allow for reducing the total power consumption of the system even further. If the cooling assembly also is configured to cool other components/elements of the system, these elements may also either be turned off or placed in an element-specific standby mode in order to ensure that no damages occur due to the cooling being turned off.

Running the system in the operating mode may comprise cooling the at least one charged particle optics element, respectively. That is, during operating mode, i.e., when running the system in operating mode, the at least one charged particle optics element may be cooled.

Running the charged particle system in the standby mode may comprise the system assuming a standby configuration. Additionally or alternatively, running the charged particle system in the operating mode may comprise the system assuming an operating configuration. That is, the system may assume particular configurations depending on the mode in which the system is run, e.g., with regard to valve positions, on/off states of system components (also referred to as system elements) etc.

The respective temperature setpoint for the associated charged particle optics element may be respectively determined during the operating mode, i.e., for each of the at least one charged particle optics element for which the respective temperature setpoint is determined, the respective temperature setpoint may be respectively determined during operating mode. In other words, it may respectively be determined during operating mode for each of the at least one of the at least one charged particle optics element, wherein it is understood that ins particular embodiments "for the at least one of the at least one" may also encompass to "each of the at least one". That is, during operating mode each of the charged particle optics elements is typically at a constant temperature, which is the result of the energy, e.g., current, provided to the charged particle optics element and the cooling due to the cooling assembly. Typically, there may be no active feedback loop between cooling and current during normal operation, as for example also in systems known in the state of the art. Thus, the respective temperature may for example be based on the respective element temperature during normal operating. In some embodiments it may simply correspond to the respective element temperature or an average thereof.

It will be understood that any respective temperature, respective current, respective setpoint and so forth is always associated to a respective charged particle optics element. Thus, whenever reference is made to "the associated charged particle optics element" the charged particle optics element associated to the respective current, setpoint, temperature and so forth is meant. In particular, the method may for example comprise determining a respective temperature setpoint for at least one of the at least one charged particle optics element, thus, for sake of brevity and readability, when reference is made to said method step, it may be referred to as determining a respective temperature setpoint for the associated charged particle optics element. Thus, the term "associated charged particle optics element" may refer to each of the at least one of the at least one charged particle optics element for which the respective parameter/variable is determined. Similarly, when referring to the respective temperature setpoint for the associated charged particle optics element, it will be understood that this refers to the respective temperature setpoint for the at least one of the at least one charged particle optics element for which the respective temperature setpoint is determined.

The respective temperature setpoint for the associated charged particle optics element may be respectively determined prior to running the charged particle system in the standby mode, i.e., for each of the at least one charged particle optics element for which the respective temperature setpoint is determined, the respective temperature setpoint may be respectively determined prior to running the charged particle system in the standby mode. In some embodiments, the respective temperature setpoint for the associated charged particle optics element may be respectively determined immediately prior to running the charged particle system in the standby mode. That is, for each of the at least one charged particle optics element for which the respective temperature setpoint is determined, the respective temperature setpoint may be respectively determined immediately prior to running the charged particle system in the standby mode. That is, the respective temperature setpoint may be determined prior to entering the standby mode, preferably immediately prior to entering the standby mode. This may advantageously allow to ensure, that the respective temperature setpoints correspond to the latest settings in operating mode.

The at least one charged particle optics element may be current driven and the method may comprise providing a respective current to each of the at least one charged particle optics element. That is, each of the at least one charged particle optics element may be provided with a respective current, wherein the current may differ for each of the at least one charged particle optics element. In such cases, the method may comprise providing a respective operating current to each of the at least one charged particle optics element when running the system in operating mode. That is, each of the at least one charged particle optics element may be provided with a respective operating current that may be different among individual charged particle optics element, and may be tailored to the specific need during operating, e.g., focal length of an electromagnetic lens. It is noted, that the system may further comprise other optics elements for charged particles which are not current driven. However, in embodiments wherein the at least one charged particle optics element is current driven, such other optics elements are not considered to be part of the at least one charged particle optics element.

The method may further comprise determining a respective current setpoint for each of the at least one charged particle optics element during the operating mode. The respective current setpoint may correspond to the respective operating current.

Stabilizing the respective element temperature may comprise providing a respective standby current to the associated charged particle optics element, i.e., to each of the at least one charged particle optics element for which the element temperature is stabilized. Further, providing the respective standby current may comprise controlling the respective standby current provided to the associated charged particle optics element. In other words, the standby current may be controlled such that the respective element temperature is stabilized to the respective temperature setpoint despite the cooling being turned off. This may advantageously result in a significantly lower standby current compared to the operating current. Additionally, controlling the respective standby current provided to the associated charged particle optics element may comprise reducing the average current compared to running the charged particle system in the operating mode. That is, at least the average current provided to the at least one charged particle optics element may be reduced. Additionally or alternatively, controlling the respective standby current provided to the associated charged particle optics element may comprise reducing the average current compared to the respective operating current. The average standby current may be reduced by at least 33 %, preferably at least 40 %, more preferably at least 50 % compared to running the charged particle system in the operating mode.

Controlling the respective standby current provided to the associated charged particle optics element may comprise modulating said standby current to reduce the average current supplied to the associated charged particle optics element. Further, modulating the respective standby current may comprise pulse width modulation (PWM). Modulating the current may advantageously allow to avoid too low currents, for which the system may not be designed, e.g., the system may not be configured to stably provide and/or measure currents below a certain threshold such as 1 A. Through modulation, the current amplitude can be higher, while the average current is still reduced based on the duty cycle and/or switching frequency of the modulated current.

Generally, the current may be modulated at a switching frequency, e.g., above a few Hz, in order to avoid relevant thermal fluctuations, i.e., thermal fluctuations beyond 5%, preferably 1% of the desired temperature. In other words, given this is a standby mode, fluctuations can be tolerated to a certain extent, whereas a transition from standby mode to operation mode may be more demanding regarding allowable fluctuations since thermal stability in the operating mode is crucial to system performance. That is, while thermal fluctuations themselves may not be an issue in standby mode, it may generally be required that the system can return back to a thermally stable operating mode in a quick and reliable manner. Thus, fluctuations in standby mode may at least be limited to an extend that allows for sufficiently fast return to a stable operating mode. Modulating the respective standby current may comprise modulation at a switching frequency of at least 0.01 Hz, preferably at least 0.1 Hz, such as 1 Hz or 3 Hz. That is, in a typical system the modulation of the standby current can be as low as 1/10 Hz. However, more generally the minimum frequency may be tied to the thermal mass of the system (and hence the thermal time constant). Thus, the switching frequency may ultimately depend on the thermal mass of the system and for example systems with a thermal mass higher than typical systems may allow for lower switching frequencies, e.g., switching frequencies below 0.1 Hz, potentially below 0.01 Hz.

Further, modulating the respective standby current may comprise modulation with a duty cycle chosen such that it is sufficient to lower the average current to a desired level and maintain the active current above the threshold of operation of the electrical driver system, e.g., the current source. Such a level of the average current may be for example typically be about 2 A for an objective lens and may be less for other lenses.

A maximum of the respective standby current may be maintained at the respective current setpoint of the associated charged particle optics element when running the system in standby mode. That is, the current setpoint of an associated charged particle optics element may be maintained when switching into standby mode, while the average current provided to the charged particle optics element is reduced due to pulse width modulation, e.g., switching on and off the current drive/source. In other words, the provided current may still be equal to the operating current, however due to modulation said current is only provided in pulses based on the modulation of the signal, such that the average current is still lower.

Modulating the respective standby current provided may comprise repeatedly switching the current source on and off. That is, a simplistic form of pulse width modulation may be achieved by repeatedly, e.g., at a fixed switching frequency, switching the current source on and off, e.g., toggling the on-off of a respective current source/driver.

The charged particle system may comprise a plurality of charged particle optics elements and the method may comprise modulating the respective standby current to associated charged particle optics elements in sequence to reduce and/or prevent power surges. In other words, the modulation of respective currents may be tuned with respect to each other such that power surges are reduced, e.g., by ensuring that as few maxima as possible overlap.

In the standby mode, the power consumption of the at least one charged particle optics element may be reduced compared to running the charged particle system in the operating mode. Particularly, the power consumption of the charged particle system running in the standby mode may be reduced by at least 33 %, preferably at least 40 %, more preferably at least 50 % compared to running the charged particle system in the operating mode. This reduction may be achieved due to the reduced standby current compared to the operating current.

The method may further comprise returning to running the system in operating mode after running the system in standby mode. That is, for example a user may indicate that the charged particle system is required in operating mode again, e.g., to perform measurements and/or imaging of a sample. Returning to running the system in operating mode may comprise reestablishing and/or starting the cooling of said or each of the at least one charged particle optics element. Further, returning to running the system in operating mode may comprise providing the respective operating current to each of the charged particle optics elements.

Additionally or alternatively, returning to running the system in operating mode may comprise determining and indicating when the respective element temperature has stabilized to the respective temperature setpoint. This may for example take at most 1 hour, preferably at most 30 minutes, more preferably at most 10 minutes, such as a few minutes. Further, determining when the respective element temperature has stabilized to the respective temperature setpoint may comprise determining a present element temperature of the associated charged particle optics element. That is, when switching the system from standby mode into operating mode, there may be a deviation of respective element temperatures from respective temperature setpoints, e.g., due to the thermal inertia of the charged particle system. Thus, the system may determine when the element temperature has again settled to the respective temperature setpoint and indicate this. This may advantageously allow for a user to know when the system is fully operational again. Indicating may for example refer to providing a visual indication such as a light, e.g., LED, or a message on a screen. However, indicating may for example also refer to changing the value of a variable, e.g., a Boolean variable, or sending a message.

Stabilizing the respective element temperature of the associated charged particle optics element may comprise determining a present element temperature of the associated charged particle optics element. That is, for each charged particle optics element, for which the respective element temperature is stabilized, said stabilizing may comprise determining a present element temperature of the associated charged particle optics element. Furthermore, controlling the respective standby current may comprise comparing the present element temperature of the associated charged particle optics element to the respective temperature setpoint and adjusting the provided respective standby current based on said comparing. Additionally or alternatively, controlling the respective standby current may comprise determining an error between the respective temperature setpoint and the present element temperature of the associated charged particle optics element and adjusting the provided respective standby current based on said error.

The respective temperature setpoint may be at least one of a temperature and an electrical resistance. That is, the temperature setpoint may be a temperature value and/or a resistance value, as a resistance is also indicative of a temperature based on a respective calibration measurement.

Determining the respective temperature setpoint for the associated charged particle optics element may comprise determining an electrical resistance of the associated charged particle optics element. That is, for each charged particle optics element, for which the respective temperature setpoint is determined, said determining may comprise determining an electrical resistance of the associated charged particle optics element. Additionally or alternatively, determining the respective temperature setpoint for the associated charged particle optics element (i.e., for each charged particle optics element for which the respective temperature setpoint is determined) may comprise determining a temperature of the associated charged particle optics element through a dedicated measurement coil and/or thermocouple attached to or within the associated charged particle optics element. In some embodiments, determining the respective temperature setpoint for the associated charged particle optics element (i.e., for each charged particle optics element for which the respective temperature setpoint is determined) may comprise determining an average temperature and/or electrical resistance for the associated charged particle optics element. Averaging temperature or electrical resistance may advantageously allow to account for small fluctuations, e.g., through modulated currents etc.

Generally, a measurement of the (average) temperature and/or resistance may be repeated such sufficiently so as to ensure that the fluctuations are within the bounds determined for an acceptable time for return to operating mode after standby mode. For example, such a measurement may be repeated at least every 1, 2, 3, 5, 7 or 10 minutes. However, in general repetition rate may also be increased for steep temperature gradients and decreased when temperature is relatively stable. In other words, the repetition rate may be adjusted based on the current temperature stability and/or during changes of the temperature, e.g., when returning to operating mode.

Generally, the average temperature and/or resistance may be determined by averaging temperature or resistance over a measuring interval. The measuring interval may for example be 1 s. However, the measurement interval may be increased or decreased depending on the noise level in the measurement. In some embodiments, determining the average temperature and/or resistance for the associated charged particle optics element may comprise averaging the temperature and/or the resistance over 0.2 to 30 s, preferably 0.5 s to 10 s, more preferably over 0.5 s to 2 s, such as 1 s.

The respective temperature setpoint may correspond to the temperature and/or electrical resistance of the associated charged particle optics element during operating mode or an average thereof. That is, the respective temperature setpoint may correspond to the temperature and/or electrical resistance of the respective associated charged particle optics element during operating mode or an average thereof.

The present element temperature may be at least one of a temperature and an electrical resistance. Determining the present element temperature of the associated charged particle optics element may comprise determining its electrical resistance. Additionally or alternatively, determining the present element temperature of the associated charged particle optics element may comprise determining a temperature of the associated charged particle optics element through a dedicated measurement coil and/or thermocouple attached to or within the associated charged particle optics element. Determining the present element temperature of the associated charged particle optics element may comprise determining an average temperature and/or electrical resistance for the associated charged particle optics element.

Again, the average temperature and/or resistance may be determined by averaging temperature or resistance over a measuring interval. The measuring interval may generally be chosen, such that a stable value may be obtained. Alternatively, a running average may be used across a plurality of sample of shorter duration. The measuring interval may for example be 1 s. However, the measurement interval may be increased or decreased depending on the noise level in the measurement. In some embodiments, determining the average temperature and/or resistance for the associated charged particle optics element comprises averaging the temperature and/or electrical resistance over 0.2 to 30 s, preferably 0.5 s to 10 s, more preferably over 0.5 s to 2 s, such as 1 s.

As mentioned above, the repetition rate may generally be chosen sufficiently so as to ensure that the fluctuations are within the bounds determined for an acceptable time for return to operating mode after standby mode. For example, such a measurement may be repeated at least every 1, 2, 3, 5, 7 or 10 minutes. However, the repetition rate may be increased for steep temperature gradients and decreased when temperature is relatively stable. In other words, the repetition rate may be adjusted based on the current temperature stability and/or presence of steep temperature gradients. In some cases, the repetition rate may also be adjusted due to using a moving average of shorter samples, where for example an increase in repetition rate may be desirable.

Determining the respective temperature setpoint may comprise determining an individual temperature setpoint for each of the associated charged particle optics element respectively. That is, for each charged particle optics element, for which the respective temperature setpoint is determined, determining the respective temperature setpoint may comprise determining an individual temperature setpoint. An individual temperature setpoint may be independent of respective temperature setpoints of other charged particle optics elements, but not necessarily different.

The respective current setpoint may correspond to the current provided to the associated charged particle optics element during the operating mode or an average thereof.

The method may further comprise employing at least one safety measure when running the system in standby mode to prevent overheating of the at least one charged particle optics element. The at least one safety measure may comprise setting a maximum-current threshold and limiting the respective standby current provided to the associated charged particle optics element to at most said maximum-current threshold. The maximum-current threshold may be set individually for each of the associated charged particle optics elements. That is, the maximum-current threshold may be set individually for each of the charged particle optics elements for which a respective standby current is provided. Alternatively, the maximum-current threshold may be set to the same value for all of the at least one charge particle optics element. The maximum-current threshold may be in the range of 5% to 70%, preferably 10% to 50%, more preferably 10% to 30% of the operating current.

The at least one safety measure may comprise setting a maximum-resistance threshold and limiting the respective standby current provided to the associated e charged particle optics element such that the electrical resistance of said current-driven charged particle optics element amounts to at most the maximum-resistance threshold. The maximum-resistance threshold may be set individually for each of the associated charged particle optics element. That is, the maximum-resistance threshold may be set individually for each of the charged particle optics elements for which a respective standby current is provided. Alternatively, the maximum resistance threshold may be set to the same value for all of the at least one charged particle optics element. The maximum-resistance threshold may be at most 150%, preferably 130% of the resistance of the associated charged particle optics element at 20°C. For example, the respective maximum-resistance threshold of an associated charged particle optics element may be 130% the R20 value for that element where R20 is the resistance of the element at 20°C ambient temperature.

The respective standby current provided to the associated charged particle optics element may be in the range of 5% to 70%, preferably 10% to 50% of the operating current when running the system in the standby mode. The current provided to the at least on charged particle optics element may be above 1A when running the system in the operating mode.

The method may comprise scheduling a standby time for automatically switching the charged particle system from running in the operating mode to running in the standby mode. Additionally or alternatively, the method may comprise scheduling an operating time for automatically switching the charged particle system from running in the standby mode to running in the operating mode. Furthermore, scheduling the operating time for automatically switching the charged particle system from running in the standby mode to running in the operating mode may comprise stabilizing the respective element temperature to the respective temperature setpoint prior to the scheduled operating time. This may for example advantageously allow to schedule times, wherein the system is automatically run in standby mode, while ensuring that it is back and operational when needed. For example, the system may automatically switch in to standby mode during periods where it is typically not used, e.g., nighttime and/or weekends. It will be understood, that such an automatic schedule may of course be overridable by a user, for example in case of working over hours.

The at least one charged particle optics element may be an electromagnetic lens. Further, the electromagnetic lens may comprise a coil. It will be understood, that the electromagnetic lens may comprise more than one coil, e.g., a plurality of coils.

The charged particle system may be a charged particle beam microscopy system. Further, the charged particle system may be an electron microscope. The electron microscope may be a scanning electron microscope. Alternatively, the electron microscope may be a transmission electron microscope. Further, the transmission electron microscope may be a scanning transmission electron microscope.

The method may comprise driving at least one of the at least one charged particle optics element such that the power dissipation is constant independent of the nett focussing power of the respective charged particle optics element for all acceleration voltages up to the maximum acceleration voltage of the charged particle system when running in operating mode. The maximum acceleration voltage may for example be one of 120 kV, 200 kV, 300 kV or 400 kV. This may also be referred to as "full constant power" as the power dissipation is kept constant over the hole acceleration voltage range of the respective system.

The method may be computer-implemented. That is, the method may advantageously be implemented on a computer, e.g., a processing device, which controls the system according to the preceding method.

Running the charged particle system in the standby mode may comprise a standby transition period prior to stabilizing the respective element temperature. That is, very generally, at the beginning of running the system in standby mode, there may be a transition period after switching the cooling off and reducing the current, e.g., due to the thermal inertia of the at least one charged particle optics element, before the respective element temperature is stabilized. The method may further comprise ramping the respective current provided to the associated charged particle optics element from the respective operating current down to the respective standby current during the standby transition period. Further, the ramping down may be chosen such that the thermal inertia of the associated optical element and/or its cooling is compensated. That is, the thermal inertia of the optical element in combination with the provided cooling, e.g., the thermal inertia of the cooling fluid may be compensated. For example, the rate of ramping down may be chosen to account for the thermal inertia. Additionally or alternatively, the progression of the ramping of the current may be chosen to account for the thermal inertia, e.g., the ramp may follow a linear, a polynomial and/or an exponential progression, or a combination thereof, also the slope may be adjusted accordingly. Such ramping of the current may allow to reduce and/or avoid temperature fluctuations during the standby transition period and/or shorten the standby transition period.

Returning to running the system in operating mode may comprise an operating transition period, wherein the method may further comprise ramping the respective current up to the respective operating current during the operating transition period. Further, the ramping up may be chosen such that the thermal inertia of the associated optical element and/or its cooling is compensated. That is, the thermal inertia of the optical element in combination with the provided cooling may be compensated, e.g., the thermal inertia of the cooling fluid may be compensated Similarly, such ramping of the current may advantageously allow to reduce and/or avoid temperature fluctuations during the operating transition period and/or shorten the operating transition period.

Determining the electrical resistance and/or average electrical resistance may comprise determining a voltage caused by a given current provided to the associated charged particle optics element. That is, for determining an electrical resistance a voltage may be determined, e.g., measured, for a known current. It will be understood, that owing to the relation between current, voltage and resistance this may then allow to determine the resistance.

In another embodiment, the present invention relates to a computer program product comprising instructions which, when the program is executed by a computer, cause the computer to carry out the method as described above.

In a further embodiment, the present invention relates to a charged particle system comprising at least one charged particle optics element, and a cooling assembly configured for cooling the at least one charged particle optics element. The at least one charged particle optics element may be current driven.

The system may be configured to assume at least two configurations, an operating configuration and a standby configuration. In the operating configuration, the system may be running in an operating mode and in the standby configuration, the system may be running in a standby mode. In the operating configuration the at least one charged particle optics element may be cooled by means of the cooling assembly. In contrast, in the standby configuration at least one of the at least one charged particle optics element may be cooled less or not cooled by means of the cooling assembly. Preferably, in the standby configuration each the at least one charged particle optics element may be cooled less or not cooled by means of the cooling assembly. A configuration of the system may for example relate to valve positions, on/off states of system components/elements, setpoints etc.

In the operating configuration, each of the at least one charged particle optics element may be provided with a respective operating current. Further, in the standby configuration, at least one of the at least one charged particle optics element may be provided with a respective standby current that is at least on average lower than the operating current. This can advantageously allow for reducing the power consumption in the standby mode and thus the overall power consumption of the system during its lifetime. Preferably, the at least one of the at least one charged particle optics element that is cooled less or not cooled by means of the cooling assembly may in the standby configuration be provided with a respective standby current that is at least on average lower than the operating current. Further preferably, in the standby configuration, each of the at least one charged particle optics element may be provided with a respective standby current that is at least on average lower than the operating current.

In the operating configuration, each of the at least one charged particle optics element may be at a respective operating temperature. The respective operating temperature may define a respective temperature setpoint for each of the at least one charged particle optics element. In the standby configuration, at least one of the at least one charged particle optics element may be stabilized to the respective temperature setpoint. This can advantageously allow to reduce and/or avoid thermal drifts. Preferably, in the standby configuration the at least one of the at least one charged particle optics element that is cooled less or not cooled by means of the cooling assembly, and/or the at least one of the at least one charged particle optics element that is provided with a respective standby current that is at least on average lower than the operating current may be stabilized to the respective temperature setpoint. Further preferably, In the standby configuration, at each of the at least one charged particle optics element may be stabilized to the respective temperature setpoint.

The system may be configured to perform the method as described above. That is, the system comprises means to carry out the respective method.

The system may comprise a control unit. The control unit may be configured to perform the method as described above. In some embodiments, the control unit may comprise a processing device. The processing device may be configured to perform the method as described above. The processing device may be at least one or a combination of a microprocessor, a CPU, a GPU, or a FPGA.

The system may comprise a plurality of charged particle optics elements. Additionally or alternatively, the at least one charged particle optics element may be an electromagnetic lens. The electromagnetic lens may comprise a coil. It will be understood that the electromagnetic lens may also comprise more than one coil, e.g. a plurality of coils.

Each of the at least one charged particle optics element may comprise a respective element temperature. The system may be configured to determine the electrical resistance and/or temperature of each of the at least one charged particle optics element. The determined electrical resistance and/or temperature is indicative of the respective element temperature.

At least one of the at least one charged particle optics element may comprise a thermocouple configured to provide a signal indicative of the respective element temperature. Additionally or alternatively, at least one of the at least one charged particle optics element may comprise a dedicated measurement coil to provide a signal indicative of the respective element temperature.

The system may be configured to determine the electrical resistance of at least one of the at least one charged particle optics element. In some embodiments, the system may be configured to determine the electrical resistance of each of the at least one charged particle optics element. The determined electrical resistance may be indicative of the respective element temperature to a respective temperature setpoint. Again, the resistance may be determined through determining, e.g., measuring, a voltage for a known current.

The system may comprise at least one closed-loop control system configured to stabilize the respective element temperature of at least one of the at least one charged particle optics element to a respective temperature setpoint. In some embodiments, the system may comprise a closed-loop control system configured to stabilize the respective element temperature to a respective temperature setpoint for each of the at least one charged particle optics element. The closed-loop control system may be a PID-controller. For example, the closed-loop control system may, based on the current element temperature and the respective temperature setpoint, control the standby current provided to the associated charged particle optics element in order to stabilize the respective element temperature to the temperature setpoint.

The system may comprise at least one pulse-width-modulation (PWM) controller for providing a modulated current. Again, such modulation can be advantageous for example when the standby current amplitude is otherwise lower than what the system is configured for.

The system may comprise a physical and/or virtual button for changing the configuration assumed by the system. This may advantageously allow a user to deliberately change the configuration assumed by the system and/or the mode the system is running in.

The charged particle system may be a charged particle beam microscopy system. Further, the charged particle system may be an electron microscope. The electron microscope may be a scanning electron microscope. Alternatively, the electron microscope is a transmission electron microscope. Further, the transmission electron microscope may be a scanning transmission electron microscope.

The cooling assembly may be configured to provide a flow of cooling fluid. Further, the cooling fluid may be water. In the standby configuration, the cooling assembly may provide a reduced flow of cooling fluid to at least one of the at least one charged particle optics element. Preferably, in the standby configuration, the cooling assembly may provide a reduced flow of cooling fluid to the at least one of the at least one charged particle optics element that may be cooled less or not cooled by means of the cooling assembly, that may be provided with a respective standby current that is at least on average lower than the operating current, and/or that is stabilized to the respective temperature setpoint. Further preferably, in the standby configuration, the cooling assembly may provide a reduced flow of cooling fluid to each of the at least one charged particle optics element. Additionally or alternatively, in the standby configuration, the cooling assembly may not provide a flow of cooling fluid to at least one of the at least one charged particle optics element. Preferably, in the standby configuration, the cooling assembly may not provide a flow of cooling fluid to the at least one of the at least one charged particle optics element that may be cooled less or not cooled by means of the cooling assembly, that may be provided with a respective standby current that is at least on average lower than the operating current, and/or that is stabilized to the respective temperature setpoint. Further preferably, in the standby configuration, the cooling assembly may not provide a flow of cooling fluid to each of the at least one charged particle optics element. In some embodiments, in the standby configuration, the cooling assembly may provide a reduced flow of cooling fluid to any system component. Further, in the standby configuration, the cooling assembly may not provide a flow of cooling fluid to any system component.

The system may comprise a charged particle source. The charged particle source may be an electron source, such as an electron gun.

The system may further comprise a detector. The detector may comprise a charge-coupled device (CCD). In some embodiments, the cooling assembly may further be configured for cooling the detector. The detector may comprise a detector standby mode. Further, the detector may be configured to not require cooling when in detector standby mode.

The system may comprise at least one power supply unit (PSU) and the at least one charged particle optics element may be connected to at least one of the at least one power supply unit.

The system may be configured to drive at least one of the at least one charged particle optics element such that the power dissipation is constant independent of the nett focussing power of the respective charged particle optics element for acceleration voltages up to a maximum acceleration voltage of the system. The maximum acceleration voltage may for example be one of 120 kV, 200 kV, 300 kV or 400 kV. This may also be referred to as "full constant power" as the power dissipation is kept constant over the hole acceleration voltage range of the respective system.

The charged particle system of the described method may be a system as described above.

In another embodiment, the present invention relates to a use of the described particle system according to the method described above.

The present invention is also defined by the following numbered embodiments.

Below, method embodiments will be discussed. These embodiments are abbreviated by the letter "M" followed by a number. Whenever reference is herein made to "method embodiments", these embodiments are meant.

M1. A method for reducing the power consumption of a charged particle system, the charged particle system comprising at least one charged particle optics element and a cooling assembly configured for cooling the at least one charged particle optics element, the method comprising the steps of
running the charged particle system in a standby mode, wherein the total power consumption of the charged particle system is reduced compared to running the charged particle system in an operating mode.

M2. The method according to the preceding method embodiment, wherein each of the at least one charged particle optics element comprises a respective element temperature; wherein the method further comprises determining a respective temperature setpoint for at least one of the at least one charged particle optics element; and wherein running the charged particle system in the standby mode comprises
reducing and/or stopping the cooling of said at least one charged particle optics element and
stabilizing the respective element temperature of said at least one charged particle optics element to the respective temperature setpoint.

M3. The method according to the preceding method embodiment, wherein the method comprises
determining a respective temperature setpoint for each of the at least one charged particle optics element;
reducing and/or stopping the cooling of each of the at least one charged particle optics element; and
stabilizing the respective element temperature of each of the at least one charged particle optics element to the respective temperature setpoint.

M4. The method according to any of the 2 preceding method embodiments, wherein stabilizing the respective element temperature comprises maintaining the respective element temperature of the corresponding charged particle optics element within 90% to 110%, preferably within 95% to 105%, more preferably within 99% to 101% of the respective temperature setpoint.

M5. The method according to any of the 3 preceding method embodiments, wherein reducing and/or stopping the cooling of said or each of the at least one charged particle optics element comprises reducing and/or stopping a flow of cooling fluid to said or each of at least one charged particle optics element, respectively.

M6. The method according to the preceding method embodiment, wherein the cooling fluid is water.

M7. The method according to any of the preceding method embodiments, wherein the cooling assembly is further configured for cooling other elements of the charged particle system.

M8. The method according to any of the preceding method embodiments, wherein running the charged particle system in the standby mode comprises turning the cooling assembly off.

M9. The method according to the preceding method embodiment, wherein turning the cooling assembly off comprises turning all elements of the system that are cooled by the cooling assembly off or placing them in a respective element-specific standby mode.

M10. The method according to any of the preceding method embodiments, wherein running the system in the operating mode comprises cooling the at least one charged particle optics element, respectively.

M11. The method according to any of the preceding method embodiments, wherein running the charged particle system in the standby mode comprises the system assuming a standby configuration.

M12. The method according to any of the preceding method embodiments, wherein running the charged particle system in the operating mode comprises the system assuming an operating configuration.

M13. The method according to any of the preceding method embodiments and with the features of M2, wherein the respective temperature setpoint for the associated charged particle optics element is respectively determined during the operating mode.

M14. The method according to any of the preceding method embodiments and with the features of M2, wherein the respective temperature setpoint for the associated charged particle optics element is respectively determined prior to running the charged particle system in the standby mode.

M15. The method according to the preceding method embodiment, wherein the respective temperature setpoint for the associated charged particle optics element is respectively determined immediately prior to running the charged particle system in the standby mode.

M16. The method according to any of the preceding method embodiments, wherein the at least one charged particle optics element is current driven and the method comprises providing a respective current to each of the at least one charged particle optics element.

That is, each of the at least one charged particle optics element is provided with a respective current, wherein the current may differ for each of the at least one charged particle optics element.

M17. The method according to the preceding method embodiment, wherein the method comprises providing a respective operating current to each of the at least one charged particle optics element when running the system in operating mode.

M18. The method according to any of the 2 preceding method embodiments, wherein the method further comprises determining a respective current setpoint for each of the at least one charged particle optics element during the operating mode.

M19. The method according to the preceding method embodiment and with the features of M17, wherein the respective current setpoint corresponds to the respective operating current.

M20. The method according to any of the 4 preceding method embodiments and with the features of M2, wherein stabilizing the respective element temperature comprises providing a respective standby current to the associated charged particle optics element.

M21. The method according to the preceding method embodiment, wherein providing the respective standby current comprises controlling the respective standby current provided to the associated charged particle optics element.

M22. The method according to the preceding method embodiment, wherein controlling the respective standby current provided to the associated charged particle optics element comprises reducing the average current compared to running the charged particle system in the operating mode.

That is, at least the average current provided to the at least one charged particle optics element is reduced.

M23. The method according to any of the 2 preceding method embodiments and with the features of M17, wherein controlling the respective standby current provided to the associated charged particle optics element comprises reducing the average current compared to the respective operating current.

M24. The method according to any of the 3 preceding method embodiments, wherein controlling the respective standby current provided to the associated charged particle optics element comprises modulating said standby current to reduce the average current supplied to the associated charged particle optics element.

M25. The method according to the preceding method embodiment, wherein modulating the respective standby current comprises pulse width modulation (PWM).

M26. The method according to any of the 2 preceding method embodiments, wherein modulating the respective standby current comprises modulation at a switching frequency of at least 0.01 Hz, preferably at least 0.1 Hz, such as 1 Hz or 3 Hz.

M27. The method according to any of the 3 proceeding method embodiments and with the features of M18, wherein a maximum of the respective standby current is maintained at the respective current setpoint of the associated charged particle optics element when running the system in standby mode.

That is, the respective current setpoint of an associated charged particle optics element may be maintained when switching into standby mode, while the average current provided to the charged particle optics element is reduced due to pulse width modulation, e.g., switching on and off the current drive/source.

M28. The method according to any of the 4 preceding method embodiments, wherein modulating the respective standby current provided comprises repeatedly switching the current source on and off.

That is, a simplistic form of pulse width modulation may be achieved by repeatedly, e.g., at a fixed switching frequency, switching the current source on and off, e.g., toggling the on-off of a respective current source/driver.

M29. The method according to any of the 5 preceding method embodiments, wherein the charged particle system comprises a plurality of charged particle optics elements and wherein the method comprises modulating the respective standby current to associated charged particle optics elements in sequence to reduce and/or prevent power surges.

M30. The method according to any of the preceding method embodiments, wherein in the standby mode the power consumption of the at least one charged particle optics element is reduced compared to running the charged particle system in the operating mode.

M31. The method according to any of the preceding method embodiments, wherein the method further comprises returning to running the system in operating mode after running the system in standby mode.

M32. The method according to the preceding method embodiment and with the features of M2, wherein returning to running the system in operating mode comprises reestablishing and/or starting the cooling of said or each of the at least one charged particle optics element, respectively.

M33. The method according to any of the 2 preceding method embodiments and with the feature of M17, wherein returning to running the system in operating mode comprises providing the respective operating current to each of the charged particle optics elements.

M34. The method according to any of the 3 preceding method embodiments and with the features of M2, wherein returning to running the system in operating mode comprises determining and indicating when the respective element temperature has stabilized to the respective temperature setpoint.

M35. The method according to the preceding method embodiment, wherein determining when the respective element temperature has stabilized to the respective temperature setpoint comprises determining a present element temperature of the associated charged particle optics element.

M36. The method according to any of the preceding method embodiments and with the features of M2, wherein stabilizing the respective element temperature of the associated charged particle optics element comprises determining a present element temperature of the associated charged particle optics element.

M37. The method according to the preceding method embodiment and with the features of M21, wherein controlling the respective standby current comprises comparing the present element temperature of the associated charged particle optics element to the respective temperature setpoint and adjusting the provided respective standby current based on said comparing.

M38. The method according to any of the 2 preceding method embodiments and with the features of M21, wherein controlling the respective standby current comprises determining an error between the respective temperature setpoint and the present element temperature of the associated charged particle optics element and adjusting the provided respective standby current based on said error.

M39. The method according to any of the preceding method embodiments and with the features of M2, wherein the respective temperature setpoint is at least one of a temperature and an electrical resistance.

M40. The method according to any of the preceding method embodiments and with the features of M2 and M16, wherein determining the respective temperature setpoint for the associated charged particle optics element comprises determining an electrical resistance of the associated charged particle optics element.

M41. The method according to any of the preceding method embodiments and with the features of M2, wherein determining the respective temperature setpoint for the associated charged particle optics element comprises determining a temperature of the associated charged particle optics element through a dedicated measurement coil and/or thermocouple attached to or within the associated charged particle optics element.

M42. The method according to any of the preceding method embodiments and with the features of M2, wherein determining the respective temperature setpoint for the associated charged particle optics element comprises determining an average temperature and/or electrical resistance for the associated charged particle optics element.

M43. The method according to the preceding method embodiment, wherein determining the average temperature and/or resistance for the associated charged particle optics element comprises averaging the temperature and/or electrical resistance over 0.2 to 30 s, preferably 0.5 s to 10 s, more preferably over 0.5 s to 2 s, such as 1 s.

M44. The method according to any of the preceding method embodiments and with the features of M2, wherein the respective temperature setpoint corresponds to the temperature and/or electrical resistance of the associated charged particle optics element during operating mode or an average thereof.

M45. The method according to any of the preceding method embodiments and with the features of M35 and/or M36, wherein the present element temperature is at least one of a temperature and an electrical resistance.

M46. The method according to any of the preceding method embodiments and with the features of M16, and M35 and/or M36, wherein determining the present element temperature of the associated charged particle optics element comprises determining its electrical resistance.

M47. The method according to any of the preceding method embodiments and with the features of M35 and/or M36, wherein determining the present element temperature of the associated charged particle optics element comprises determining a temperature of the associated charged particle optics element through a dedicated measurement coil and/or thermocouple attached to or within the associated charged particle optics element.

M48. The method according to any of the preceding method embodiments and with the features of M35 and/or M36, wherein determining the present element temperature of the associated charged particle optics element comprises determining an average temperature and/or electrical resistance for the associated charged particle optics element.

M49. The method according to the preceding method embodiment, wherein determining the average temperature and/or resistance for the associated charged particle optics element comprises averaging the temperature and/or electrical resistance over 0.2 to 30 s, preferably 0.5 s to 10 s, more preferably over 0.5 s to 2 s, such as 1 s.

M50. The method according to any of the preceding method embodiments and with the features of M2, wherein determining the respective temperature setpoint comprises determining an individual temperature setpoint for the associated charged particle optics element respectively.

M51. The method according to any of the preceding method embodiments and with the features of M18, wherein the respective current setpoint corresponds to the current provided to the associated charged particle optics element during the operating mode or an average thereof.

M52. The method according to any of the preceding method embodiments, wherein the method comprises employing at least one safety measure when running the system in standby mode to prevent overheating of the at least one charged particle optics element.

M53. The method according to the preceding method embodiment and with the features of M20, wherein the at least one safety measure comprises setting a maximum-current threshold and limiting the respective standby current provided to the associated charged particle optics element to at most said maximum-current threshold.

M54. The method according to the preceding method embodiment, wherein the maximum-current threshold is set individually for each of the associated charged particle optics elements.

M55. The method according to the penultimate method embodiment, wherein the maximum-current threshold is set to the same value for all of the at least one charge particle optics element.

M56. The method according to any of the 3 preceding method embodiments and with the features of M17, wherein the maximum-current threshold is in the range of 5% to 70 %, preferably 10% to 50%, more preferably 10% to 30% of the operating current.

M57. The method according to any of the 5 preceding method embodiment and with the features of M20, wherein the at least one safety measure comprises setting a maximum-resistance threshold and limiting the respective standby current provided to the associated charged particle optics element such that the electrical resistance of said current-driven charged particle optics element amounts to at most the maximum-resistance threshold.

M58. The method according to the preceding method embodiment, wherein the maximum-resistance threshold is set individually for each of the associated charged particle optics element.

M59. The method according to the penultimate method embodiment, wherein the maximum-resistance threshold is set to the same value for all of the at least one charged particle optics element.

M60. The method according to any of the 3 preceding method embodiments, wherein the maximum-resistance threshold is at most 150%, preferably 130 % of the resistance of the associated charged particle optics element at 20°C.

M61 The method according to any of the preceding method embodiments and with the features of M20 and M17, wherein the respective standby current provided to the associated charged particle optics element is in the range of 5% to 70 %, preferably, 10% to 50% of the operating current when running the system in the standby mode.

M62. The method according to any of the preceding method embodiments and with the features of M16, wherein the respective current provided to the at least on charged particle optics element is above 1A when running the system in the operating mode.

M63. The method according to any of the preceding method embodiments and with the features of M22, wherein the average standby current is reduced by at least 33 %, preferably at least 40 %, more preferably at least 50 % compared to running the charged particle system in the operating mode.

M64. The method according to any of the preceding method embodiments, wherein the power consumption of the charged particle system running in the standby mode is reduced by at least 33 %, preferably at least 40 %, more preferably at least 50 % compared to running the charged particle system in the operating mode.

M65. The method according to any of the preceding method embodiments, wherein the method comprises scheduling a standby time for automatically switching the charged particle system from running in the operating mode to running in the standby mode.

M66. The method according to any of the preceding method embodiments, wherein the method comprises scheduling an operating time for automatically switching the charged particle system from running in the standby mode to running in the operating mode.

M67. The method according to the preceding method embodiment, wherein scheduling the operating time for automatically switching the charged particle system from running in the standby mode to running in the operating mode comprises stabilizing the respective element temperature to the respective temperature setpoint prior to the scheduled operating time.

M68. The method according to any of the preceding method embodiments, wherein the at least one charged particle optics element is an electromagnetic lens.

M69. The method according to the preceding method embodiment, wherein the electromagnetic lens comprises a coil.

M70. The method according to any of the preceding method embodiments, wherein the charged particle system is a charged particle beam microscopy system.

M71. The method according to any of the preceding method embodiments, wherein the charged particle system is an electron microscope.

M72. The method according to the preceding method embodiment, wherein the electron microscope is a scanning electron microscope.

M73. The method according the penultimate method embodiment, wherein the electron microscope is a transmission electron microscope.

M74. The method according to the preceding method embodiment, wherein the transmission electron microscope is a scanning transmission electron microscope.

M75. The method according to any of the preceding method embodiments, wherein the method is computer-implemented.

M76. The method according to any of the preceding method embodiments, wherein running the charged particle system in the standby mode comprises a standby transition period prior to stabilizing the respective element temperature.

M77. The method according to the preceding method embodiment and with the features of M17 and M20, wherein the method further comprises ramping the respective current provided to the associated charged particle optics element from the respective operating current down to the respective standby current during the standby transition period.

M78. The method according to the preceding method embodiment, wherein the ramping down is chosen such that the thermal inertia of the associated optical element and/or its cooling is compensated.

M79. The method according to any of the preceding method embodiments and with the features of M31, wherein returning to running the system in operating mode comprises an operating transition period, wherein the method further comprises ramping the respective current up to the respective operating current during the operating transition period.

M80. The method according to the preceding method embodiment, wherein the ramping up is chosen such that the thermal inertia of the associated optical element and/or its cooling is compensated.

M81. The method according to any of the preceding method embodiments and with the features of at least one of M40, M42, M46 and M48, wherein determining the electrical resistance and/or average electrical resistance comprises determining a voltage caused by a given current provided to the associated charged particle optics element.

M82. The method according to any of the preceding method embodiments and with the features of M16, wherein the method comprises driving at least one of the at least one charged particle optics element such that the power dissipation is constant independent of the nett focussing power of the respective charged particle optics element for all acceleration voltages up to the maximum acceleration voltage of the charged particle system when running in operating mode.

Below, computer program embodiments will be discussed. These embodiments are abbreviated by the letter "C" followed by a number. Whenever reference is herein made to "computer program embodiments", these embodiments are meant.

C1. A computer program product comprising instructions which, when the program is executed by a computer, cause the computer to carry out the method according to any of the preceding method embodiments.

Below, reference will be made to charged particle system embodiments. These embodiments are abbreviated by the letter "S" followed by a number. Whenever reference is herein made to "system embodiments", these embodiments are meant.

S1. A charged particle system comprising
at least one charged particle optics element; and
a cooling assembly configured for cooling the at least one charged particle optics element.

S2. The charged particle system according to the preceding system embodiment, wherein the at least one charged particle optics element is current driven.

S3. The charged particle system according to any of the preceding system embodiments, wherein the system is configured to assume at least two configurations, an operating configuration and a standby configuration.

S4. The charged particle system according to the preceding system embodiment, wherein in the operating configuration the system is running in an operating mode and wherein in the standby configuration the system is running in a standby mode.

S5. The charged particle system according to any of the 2 preceding system embodiments, wherein in the operating configuration the at least one charged particle optics element is cooled by means of the cooling assembly.

S6. The charged particle system according to any of the 3 preceding system embodiments, wherein in the standby configuration at least one of the at least one charged particle optics element is cooled less or not cooled by means of the cooling assembly.

S7. The charged particle system according to any of the 4 preceding system embodiments, wherein in the standby configuration each of the at least one charged particle optics element is cooled less or not cooled by means of the cooling assembly.

S8. The charged particle system according to any of the 5 preceding system embodiments and with the features of S2, wherein in the operating configuration each of the at least one charged particle optics element is provided with a respective operating current.

S9. The charged particle system according to the preceding system embodiment, wherein in the standby configuration at least one of the at least one charged particle optics element is provided with a respective standby current that is at least on average lower than the operating current.

S10. The charged particle system according to any of the 2 preceding system embodiments and with the features of S6, wherein in the standby configuration the at least one of the at least one charged particle optics element that is cooled less or not cooled by means of the cooling assembly is provided with a respective standby current that is at least on average lower than the operating current.

S11. The charged particle system according to the preceding system embodiment, wherein in the standby configuration each of the at least one charged particle optics element is provided with a respective standby current that is at least on average lower than the operating current.

S12. The charged particle system according to any of the preceding system embodiments and with the features of S3, wherein in the operating configuration each of the at least one charged particle optics element is at a respective operating temperature.

S13. The charged particle system according to the preceding system embodiment, wherein the respective operating temperature defines a respective temperature setpoint for each of the at least one charged particle optics element.

S14. The charged particle system according to the preceding system embodiment, wherein in the standby configuration at least one of the at least one charged particle optics element is stabilized to the respective temperature setpoint.

S15. The charged particle system according to any of the 2 preceding system embodiments and with the features of S6 or S11, wherein in the standby configuration the at least one of the at least one charged particle optics element that is cooled less or not cooled by means of the cooling assembly, and/or the at least one of the at least one charged particle optics element that is provided with a respective standby current that is at least on average lower than the operating current is stabilized to the respective temperature setpoint.

S16. The charged particle system according to any of the 3 preceding system embodiments, wherein in the standby configuration each of the at least one charged particle optics element is stabilized to the respective temperature setpoint.

S17. The charged particle system according to any of the preceding system embodiments, wherein the system is configured to perform the method according to any of the preceding method embodiments.

That is, the system comprises the means to carry out the respective method.

S18. The charged particle system according to any of the preceding system embodiments, wherein the system comprises a control unit.

S19. The charged particle system according to the preceding system embodiment, wherein the control unit is configured to perform the method according to any of the preceding method embodiments.

S20. The charged particle system according to any of the 2 preceding system embodiments, wherein the control unit comprises a processing device.

S21. The charged particle system according to the preceding system embodiment, wherein the processing device is configured to perform the method according to any of the preceding method embodiments.

S22. The charged particle system according to any of the 2 preceding system embodiments, wherein the processing device is at least one or a combination of a microprocessor, a CPU, a GPU, or a FPGA.

S23. The charged particle system according to any of the preceding system embodiments, wherein the system comprises a plurality of charged particle optics elements.

S24. The charged particle system according to any of the preceding system embodiments, wherein the at least one charged particle optics element is an electromagnetic lens.

S25. The charged particle system according to the preceding system embodiment, wherein the electromagnetic lens comprises a coil.

S26. The charged particle system according to any of the preceding system embodiments, wherein each of the at least one charged particle optics element comprises a respective element temperature.

S27. The charged particle system according to any of the preceding system embodiments, wherein the system is configured to determine the electrical resistance and/or temperature of each of the at least one charged particle optics element.

S28. The charged particle system according to the preceding system embodiment and with the features of S26, wherein the determined electrical resistance and/or temperature is indicative of the respective element temperature.

S29. The charged particle system according to any of the preceding system embodiments and with the features of S26, wherein at least one of the at least one charged particle optics element comprises a thermocouple configured to provide a signal indicative of the respective element temperature.

S30. The charged particle system according to any of the preceding system embodiments and with the features of S26, wherein at least one of the at least one charged particle optics element comprises a dedicated measurement coil to provide a signal indicative of the respective element temperature.

S31. The charged particle system according to any of the preceding system embodiments, wherein the system is configured to determine the electrical resistance of at least one of the at least one charged particle optics element.

S32. The charged particle system according to any of the preceding system embodiments, wherein the system is configured to determine the electrical resistance of each of the at least one charged particle optics element.

S33. The charged particle system according to any of the 2 preceding system embodiment and with the features of S26, wherein the determined electrical resistance is indicative of the respective element temperature to a respective temperature setpoint.

S34. The charged particle system according to any of the preceding system embodiments and with the features of S26, wherein the system comprises at least one closed-loop control system configured to stabilize the respective element temperature of at least one of the at least one charged particle optics element to a respective temperature setpoint.

S35. The charged particle system according to any of the preceding system embodiments and with the features of S26, wherein the system comprises a closed-loop control system configured to stabilize the respective element temperature to a respective temperature setpoint for each of the at least one charged particle optics element.

S36. The charged particle system according to any of the 2 preceding system embodiments, wherein the closed-loop control system is a PID-controller.

S37. The charged particle system according to any of the preceding system embodiments, wherein the system comprises at least one pulse-width-modulation (PWM) controller for providing a modulated current.

S38. The charged particle system according to any of the preceding system embodiments, wherein the system comprises physical and/or virtual button for changing the configuration assumed by the system.

S39. The charged particle system according to any of the preceding system embodiments, wherein the charged particle system is a charged particle beam microscopy system.

S40. The charged particle system according to the preceding system embodiment, wherein the charged particle system is an electron microscope.

S41. The charged particle system according to the preceding system embodiment, wherein the electron microscope is a scanning electron microscope.

S42. The charged particle system according to the penultimate system embodiment, wherein the electron microscope is a transmission electron microscope.

S43. The charged particle system according to the preceding system embodiment, wherein the transmission electron microscope is a scanning transmission electron microscope.

S44. The charged particle system according to any of the preceding system embodiments, wherein the cooling assembly is configured to provide a flow of cooling fluid.

S45. The charged particle system according to the preceding system embodiment, wherein the cooling fluid is water.

S46. The charged particle system according to any of the preceding system embodiments and with the features of S3, wherein in the standby configuration the cooling assembly provides a reduced flow of cooling fluid to at least one of the at least one charged particle optics element.

S47. The charged particle system according to the preceding system embodiment, wherein the reduced flow of cooling fluid is provided to the at least one of the at least one charged particle optics element of system embodiment S6, S9, or S14.

S48. The charged particle system according to any of the preceding system embodiments and with the features of S3, wherein in the standby configuration the cooling assembly provides a reduced flow of cooling fluid to each of the at least one charged particle optics element.

S49. The charged particle system according to any of the preceding system embodiments and with the features of S3, wherein in the standby configuration the cooling assembly does not provide a flow of cooling fluid to at least one of the at least one charged particle optics element.

S50. The charged particle system according to the preceding system embodiment, wherein in the standby configuration the cooling assembly does not provide a flow of cooling fluid to the at least one of the at least one charged particle optics element of system embodiment S6, S9, or S14.

S51. The charged particle system according to any of the preceding system embodiments and with the features of S3, wherein in the standby configuration the cooling assembly does not provide a flow of cooling fluid to each of the at least one charged particle optics element.

S52. The charged particle system according to any of the preceding system embodiments and with the features of S3, wherein in the standby configuration the cooling assembly provides a reduced flow of cooling fluid to any system component.

S53. The charged particle system according to any of the preceding system embodiments and with the features of S3, wherein in the standby configuration the cooling assembly does not provide a flow of cooling fluid to any system component.

S54. The charged particle system according to any of the preceding system embodiments, wherein the system comprises a charged particle source.

S55. The charged particle system according to the preceding system embodiment, wherein the charged particle source is an electron source, such as an electron gun.

S56. The charged particle system according to any of the preceding system embodiments, wherein the system further comprises a detector.

S57. The charged particle system according to the preceding system embodiment, wherein the detector comprises a charge-coupled device (CCD).

S58. The charged particle system according to any of the 2 preceding system embodiments, wherein the cooling assembly is further configured for cooling the detector.

S59. The charged particle system according to any of the 4 preceding system embodiments, wherein the detector comprises a detector standby mode.

S60. The charged particle system according to the preceding system embodiment, wherein the detector is configured to not require cooling when in detector standby mode.

S61. The charged particle system according to any of the preceding system embodiments and with the features of S2, wherein the system comprises at least one power supply unit (PSU) and wherein the at least one charged particle optics element is connected to at least one of the at least one power supply unit.

S62. The charged particle system according to any of the preceding system embodiments and with the features of S2, wherein the system is configured to drive at least one of the at least one charged particle optics element such that the power dissipation is constant independent of the nett focussing power of the respective charged particle optics element for acceleration voltages up to a maximum acceleration voltage of the charged particle system.

M83. The method according to any of the preceding method embodiments, wherein the charged particle system is a system according to any of the preceding system embodiments.

Below, reference will be made to use embodiments. These embodiments are abbreviated by the letter "U" followed by a number. Whenever reference is herein made to "use embodiments", these embodiments are meant.

U1. Use of the charged particle system according to any of the preceding system embodiments according to the method of any of the preceding method embodiments.

### Brief description of drawings

- Fig. 1a: depicts the kWh-consumption of an exemplary TEM system;
- Fig. 1b: depicts the relative kWh-consumption of an exemplary TEM system;
- Fig. 2a: schematically depicts a charged particle system;
- Fig. 2b: schematically depicts a transmission electron microscope;
- Fig. 3: depicts an embodiment of the method according to the present invention; and
- Fig. 4: depicts another embodiment of the method according to the present invention.

### Detailed description

It is noted that not all the drawings carry all the reference signs. Instead, in some of the drawings, some of the reference signs have been omitted for the sake of brevity and simplicity of the illustration. Embodiments of the present invention will now be described with reference to the accompanying drawings. These embodiments should only exemplify, but not limit, the present invention. For the sake of clarity, some features may only be shown in some figures, and others may be omitted. However, also the omitted features may be present, and the depicted and discussed features do not need to be present in all embodiments.

There is a general need to reduce power consumption in all kinds of areas to save energy, reduce greenhouse gas equivalents, potentially comply with regulations, and/or cut costs. With respect to a charged particle system, such as a TEM, it is however at present difficult to save energy as shutting down the system comes at the cost of thermal drifts and misalignments of the system due to the system cooling down, as well as stabilization times of hours before everything is properly tempered and stable.

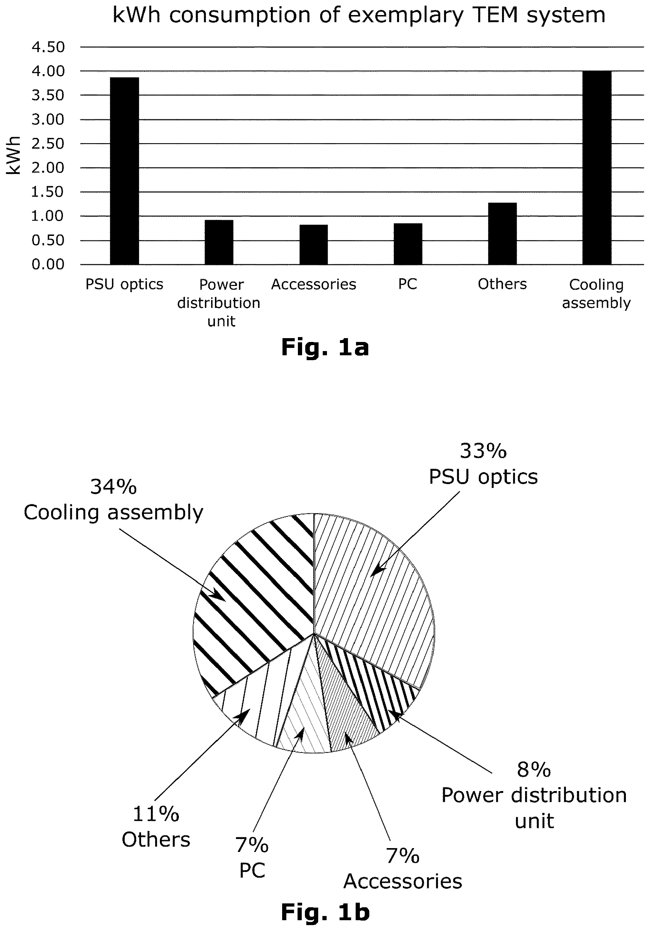

As can be seen in Figs. 1a and 1b, the biggest portion of the energy consumption of a typical TEM system comes from the power supply unit (PSU) of the optics, i.e., of the charged particle optics elements and the cooling assembly, also referred to as chiller. In particular, Fig. 1a depicts the kWh consumption of an exemplary TEM system, broken down by different system components. The total energy consumption in this example amounts to roughly 12 kWh. In Fig. 1b the relative share of the energy consumption of the system components in the total energy consumption is depicted. It can be seen, that the PSU of the charged particle optics elements in combination with the cooling assembly together amount to 67% of the total energy consumption of the exemplary TEM system. Consequently, it has been identified the highest potential for saving energy when the system is idle, i.e., unused, lies within these two components. Furthermore, the energy consumption of the cooling assembly largely depends on the energy consumption of the PSU of the charged particle optics element or more generally the charged particle optics elements.

In other words, based on an analysis of an exemplary system, it has been seen that a significant portion of power usage in a TEM microscope can be attributed to the optics system and the cooling (via water) of that system in order to maintain temperature stability and performance. That is, the optics and stabilizing via the cooling assembly, e.g., chiller, is a major use of power. While the above analysis has been performed on a particular system, it similarly applies to other charged particle systems. In short, it is desirable for the system (lifetime) power usage (and greenhouse gas equivalent) if the charged particle optics elements could be turned off during system idle times, while still maintaining thermal stability at least to a certain degree, that allows to return back to full operation within a significantly shorter amount of time compared to staring the system from being completely turned off.

In view of the above findings, the present invention is directed at a method that allows for reducing the power consumption of a charged particle system and a corresponding charged particle system. That is, the underlying idea is to avoid or minimize thermal drifts by not turning off the power completely, but to reduce power consumption while keeping the charged particle optics elements at the same temperature. Thus, shortly summarized a standby mode is provided by turning off the cooling, e.g., water cooling, of the charged particle optics elements, while still providing the charged particle optics elements with sufficient current for maintaining its temperature.

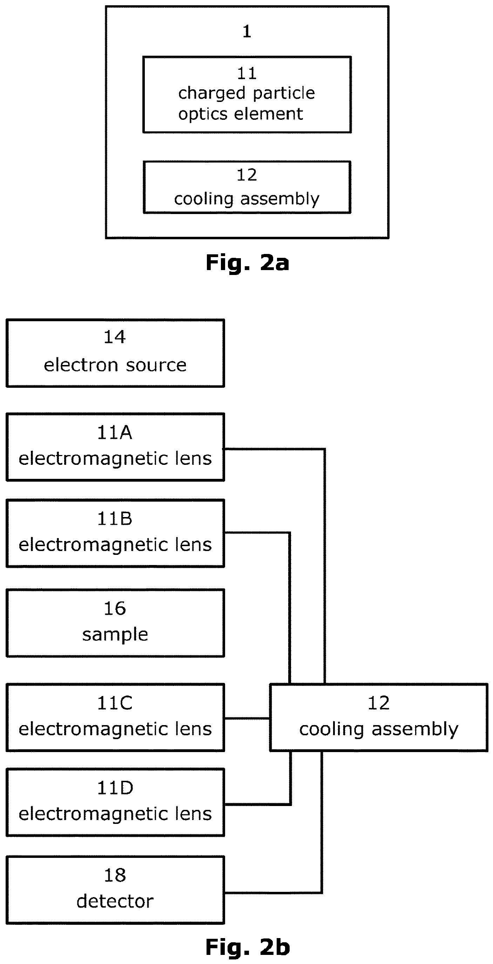

With reference to Fig. 2a, schematically depicts a very basic example of a charged particle system 1 according to the present invention, wherein the charged particle system comprises at least one charged particle optics element 11 and a cooling assembly 12 configured for cooling the at least one charged particle optics element. The system is further configured to assume at least two configurations, an operating configuration and a standby configuration. Typically, the at least one charged particle optics element 11 is current driven. Thus, it may be connected to a power supply unit. In some embodiments, a plurality of charged particle optics elements 11 may share a power supply unit (PSU), for example all charged particle optics elements 11 may share a single power supply unit (PSU), which may be configured to provide the charged particle optics elements 11 with individual respective currents. In other embodiments, each charged particle optics element 11 may be connected to an individual PSU.

A charged particle system 1 may for example be a charged particle beam microscopy system, such as an electron microscope, e.g., a scanning electron microscope (SEM), a transmission electron microscope (TEM) or a scanning transmission electron microscope (STEM). In particular, the charged particle system may also relate to a TEM system for life science, material science and/or semiconductors. Fig. 2b for example schematically depicts a transmission electron microscope comprising an electron source 14, also referred to as electron gun 14 (more generally charged particle source 14) for providing an electron beam, a plurality of electromagnetic lenses 11, 11A-11D, which are a specific type of charged particle optics elements 11 and may for example a condenser lens system, a diffraction lens, an objective lens, a projector lens etc. Furthermore, the TEM may comprise a sample 16 or more generally a sample port for providing the sample and a detector 18, such as a CCD.

It will be understood by the person skilled in the art, that the charged particle system 1 and particularly also the TEM may comprise further components not depicted in Figs. 2a and 2b, such as a vacuum system, a control unit, etc. That is, Figs. 2a and 2b do not necessarily depict all system components, but focus on components relevant to the present invention and the understanding thereof.

When such a charged particle system 1 is in the operating configuration, the at least one charged particle optics element 11, e.g., the at least one electromagnetic lens 11, 11A-11D, may be cooled by means of the cooling assembly 12. The cooling assembly may provide a flow of cooling liquid, e.g., water, to each of the components cooled, which may for example additionally include the detector 18. In addition, each of the at least one charged particle optics element 11, 11A-11D, may be provided with a respective operating current. The operating current may be the current required for normal operation of the charged particle system 1. While the respective operating current may lead to heating of the corresponding charged particle optics element, this may be counteracted by the cooling of the cooling assembly, such that each of the at least one charged particle optics element 11, 11A-11D, may be at a respective operating temperature. In particular the temperature of each charged particle optics element 11, 11A-11D may stabilize/settle to a respective operating temperature, such that the charged particle system is thermally stable and thermal drifts are at least strongly reduced or preferably avoided. Thus, the respective operating temperature may define a temperature setpoint for each of the at least one charged particle optics element 11, 11A-11D.

In contrast, when the charged particle system 1, such as the TEM, assumes the standby configuration, at least one or all of the at least one charged particle optics element 11, 11A-11B, are cooled less or not cooled by means of the cooling assembly. Thus, the flow of cooling liquid to at least one charged particle optics element 11, 11A-11B may be reduced or completely turned off. To counteract the reduced cooling (e.g., no cooling) of the respective charged particle optics element 11, 11A-11D it is provided with a respective standby current that is at least on average lower than the operating current. In particular, the temperature of at least one or each of the charged particle optics element 11, 11A-11D may be stabilized to the respective temperature setpoint. Very generally, this may be achieved by controlling the provided respective standby current. The stabilization of the temperature and thus control of the standby current, may be provided with a closed-loop control system, e.g., a PID-controller.

The respective standby current may be pulse-width modulated for such that is at least on average lower than the respective operating current. In this regard, the charged particle system 1 (also simply referred to as system 1) may comprise a pulse-with-modulation (PWM) controller.

In some embodiments, the system 1 may comprise a physical and/or virtual button, e.g., a software button, for changing the configuration assumed by the system. That is, the system 1 may comprise a button allowing a user to switch the system from the operating configuration into the standby configuration.

Very generally, the system 1 may be configured to perform the method according to the present invention, which is further described below. The system 1 may comprise a control unit (e.g., a PC), which may comprise a processing device, such as a microprocessor, a CPU, a GPU, or a FPGA. The control unit and/or the processing device may be configured to perform the method according to the present invention.

Very generally the method for reducing the power consumption of a charged particle system 1 comprising at least one charged particle optics element 11, 11A-11D and a cooling assembly 12 configured for cooling the at least one charged particle optics element11, 11A-11D, comprises the step 22 of of running the charged particle system 1 in a standby mode, wherein the total power consumption of the charged particle system 1 is reduces compared to running the charged particle system 1 in an operating mode.

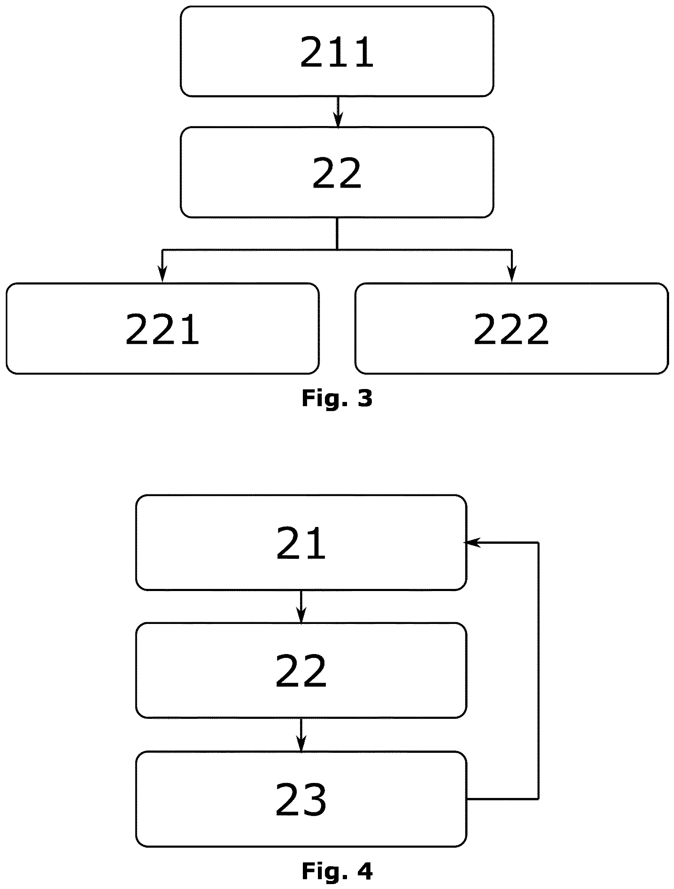

With respect to Fig. 3 the method may comprise step 211 of determining a respective temperature setpoint for each of the at least one charged particle optics element 11, 11A-11D, step 22 of running the charged particle system 1 in a standby mode, wherein the total power consumption of the charged particle system 1 is reduces compared to running the charged particle system 1 in an operating mode, step 221 of reducing and/or stopping the cooling of at least one of the at least one charged particle optics element when running the system 1 in the standby mode and step 222 of stabilizing the respective element temperature of said at least one of the at least one charged particle optics element (also referred to as associated charged particle element) to the respective temperature setpoint.

In other words, a respective temperature setpoint may be determined, preferably prior to entering the standby mode, i.e., in the operating mode, for each of the at least one charged particle optics element (step 211). That is, for each of the at least one charged particle optics element 11, 11A-11D a respective temperature setpoint may be determined, e.g., an individual temperature setpoint for each of the at least one charged particle optics element respectively. Determining the respective temperature setpoint may comprise determining a temperature, an electrical resistance, an average temperature and/or an average electrical resistance for the associated charged particle optics element.

Very generally a resistance of a charged particle optics element may be determined by determining/measuring the voltage caused by a given current. The resistance may generally be a measure of the temperature of the charged particle optics element, wherein the temperature may be determined utilizing a resistance value of the charged particle optics element calibrated at a known temperature and applying a respective thermal coefficient of the conducting material of the charged particle optics element, e.g., copper, across the difference.

Running the system in standby mode (step 221) may comprise to reduce and/or stop the cooling of at least one of the at least one charged particle optics element, preferably of each. In other words, the cooling for at least one of the at least one charged particle optics element 11, 11A-11D, preferably each of the at least one charged particle optics element 11, 11A-11D, may be reduced and/or stopped, preferably stopped. This may include reducing and/or stopping a flow of cooling fluid to the at least one of the at least one charged particle optics element. In some embodiments, the cooling assembly may be turned off completely, if all elements cooled by the cooling assembly can be accommodated. In embodiments, wherein the cooling assembly 12 is further configured for cooling other elements of the charged particle system 1, these elements may also be turned off or placed in a respective element-specific standby mode.

It can be estimated that a chiller of an exemplary TEM system, such as a TEM system for which the measurements in Figs. 1a and 1b are provided, carries off between about 3-4 kW of heat by means of the cooling fluid, e.g., water. Thus, when turning the water cooling of the charged particle optics in such a system off, the optics dissipation can be reduced by this amount while maintaining the same temperature and additionally about 1-2 kW (based on the chillers efficiency) can also be saved owing to the chiller needing to provide less cooling power.

Furthermore, running the system in standby mode may also comprise stabilizing the respective element temperature of the at least one charged particle optics element for which the cooling is reduced and/or stopped, to the respective temperature setpoint. This may typically happen simultaneously to step 221. That is, steps 221 and 222 may typically be performed simultaneously, when running the system in operating mode (step 22). Particularly, steps 221 and 222 are comprised by step 22, i.e., thy may be considered sub steps of method step 22.

Very generally, the method may comprise running the system 1 in the operating mode (step 21) and running the system in the standby mode (step 22). Running the system 1 in the standby mode may comprise the system 1 assuming the standby configuration, whereas running the system 1 in the operating mode may comprise the system 1 assuming the operating configuration.

As already discussed with respect to the system 1 embodiments, the at least one charged particle optics element 11, 11A-11D may preferably be current driven and the method may thus comprise providing a respective current to each of the at least one charged particle optics element 11, 11A-11D, wherein the provided current may differ for each of the at least one charged particle optics element. The current may be provided by a respective PSU to which the at least one charged particle optics element is connected. For example, each charged particle optics element may be connected to an individual PSU or a plurality (e.g., all) charged particle optics elements may be connected to a single PSU, configured to individually provide each charged particle optics element with a respective current.

With reference to Fig. 3, when running the system in the operating mode, a respective operating current may be provided to each of the at least one charged particle optics element 11, 11A-11D (step 212). Furthermore, a respective current setpoint may be determined for each of the at least one charged particle optics elements during the operating mode (step 213), i.e., during running the system in operating mode. Said respective current setpoint may correspond to the respective operating current.

Again, it will be understood that steps 211, 212 and 213 comprised by step 21, i.e., these represent sub steps of the step 21, which may for example carried out simultaneously.

Referring to Fig. 2 again, step 222 of stabilizing the respective element temperature may comprise providing a respective standby current to to at least one, preferably each of the at least one charged particle optics element. Said respective standby current may be controlled, such that the average current is reduced compared to running the charged particle system in the operating mode, or in other words compared to the respective operating current.

In particular, a present element temperature of the respective/associated charged particle optics element may be determined, e.g., through measuring the electrical resistance (also simply referred to as resistance) or through a dedicated temperature sensor, and compared to the respective temperature setpoint. The provided respective standby current may be adjusted based on the comparison. Comparing may particularly include determining an error between the respective temperature setpoint and the present element temperature and adjusting the respective standby current based on said error. In some cases, an average temperature or electrical resistance may be determined when determining the present element temperature and/or the respective temperature setpoint. Particularly, the present element temperature of the associated charged particle optics element and the respective temperature setpoint may refer to a temperature and/or an electrical resistance.

In other words, the electrical resistance of at least one current-driven charged particle optics element may be measured as a measure of temperature and this value may be used when entering standby mode as a respective temperature setpoint to control the respective current provided to said at least one charged particle optics element. The resistance of charged particle optics elements is advantageously already measured in known charged particle systems for over-temperature protection during normal use, e.g., using software routines. Thus, or example a software routine can be set up such that when entering standby mode is requested the resistance (or averaged resistance) may be logged and used as temperature setpoint to drive the respective current of the charged particle optics element, while cooling of the charged particle optics element is preferably turned off. Advantageously, the respective current provided in standby mode may drop significantly once the cooling is turned off, while the corresponding charged particle optics element is stabilized to the respective temperature setpoint. The respective current may for example drop by at least 33%.

A dedicated temperature sensor may for example be a dedicated measurement coil and/or a thermocouple. Such a dedicated sensor may advantageously allow to achieve a more robust and/or easier implementation.

In some embodiments, controlling the respective standby current may comprise modulating the provided current. This may particularly be beneficial, if otherwise only very small standby currents would be required, which may be hard to be read/controlled. Through modulating the current, a higher current may be applied to the coil for a limited amount of time. In other words, the provided current may be modulated such that the respective standby current is modulated and on average lower than the operating current. While such modulations may lead to slight variations in the temperature of the respective/associated charged particle optics element, e.g., one or more coils, this variation will be known based on the duty cycle of the modulation which may allow to choose the correct resistance value for determining the temperature of the charged particle optics element. For example, determining the resistance of current-driven charged particle optics elements, e.g., coils, with sufficient accuracy may require a current of at least 1 Ampere. Thus, if for example a respective standby current would be below 1 Ampere for stabilizing the respective element temperature, modulation may advantageously allow to still accurately determine the resistance. Modulating the current may comprise pulse width modulation (PWM) also referred to as duty cycle modulation.

When modulating the respective standby current, the maximum of the modulated current, i.e., during the "on" portion may be maintained at the respective current setpoint for the operating mode. While the average standby current is of course lower due to the modulation. Thus, in a very simplified version, the PSU unit may basically be switched on and off while the current provided in the "on" state is maintained at the current setpoint of the operating mode.

To reduce and/or prevent power surges when modulating the respective standby currents of a plurality of charged particle optics elements, the respective standby currents may be modulated in sequence. That is, the modulation of respective standby currents may be coordinated in such a way, that maxima of different standby currents appear at different times to reduce the overall maximum power required. Such a modulation may be characterized by its switching frequency and/or duty cycle. Similar to methods already known for powering up a system.

In some embodiments, the method may further comprise employing at least one safety measure when running the system in standby mode to prevent overheating of the at least one charged particle optics element. For example, a maximum-current threshold and/or a maximum-resistance threshold may be set to limit the respective standby current. These thresholds may be set individually for each of the at least one charged particle optics element (which does not exclude some of the charged particle optics elements having the same threshold) or alternatively such thresholds may be set to the same value for all of the at least one charge particle optics element. Providing such thresholds may particularly be advantageous, as machine safety needs to be ensured also during standby mode. In this regard, in current charged particle systems, charged particle optics elements may only be operated when cooling fluid is flowing, i.e., there may be an interlock. However, for entering standby mode, such protection must be overwritten and therefore other means for safety of the system and particularly the charged particle optics elements need to be established.

Furthermore, it is noted that in some embodiments, running the charged particle system in the standby mode comprises a standby transition period prior to stabilizing the respective element temperature. That is, upon switching from running in the operating mode to running in the standby mode an initial standby transition period may be entered. During the standby transition period the respective current provided to the at least one charged particle optics element may be ramped from the operating current down to the respective standby current. Preferably, the ramping down is chosen such that the thermal inertia of the respective optical element is compensated.

Overall, the method may thereby allow to reduce the power consumption of the at least one charged particle optics element and the cooling assembly compared to running the charged particle system in the operating mode. However, as the temperature is stabilized to the respective temperature setpoint, thermal drifts are at least reduced if not avoided and the system will stabilize much faster after returning to running in the operating mode compared to shutting the system 1 off and turning it back on. For example, the average standby current may be reduced by at least 33%, preferably at least 40 %, more preferably at least 50 % compared to running the charged particle system in the operating mode. Similarly, the power consumption of the charged particle system running in the standby mode may be reduced by at least 33 %, preferably at least 40 %, more preferably at least 50 % compared to running the charged particle system in the operating mode.

With respect to Fig. 4 the method may further comprise the step 23 of returning to running the system in operating mode after running the system in standby mode. As indicated in Fig. 4, once running the system again in operating mode (step 21), it may again be switched to running in standby mode (step 22). Returning to running the system in operating mode may comprise an operating transition period, wherein the respective current provided to the at least one charged particle optics element is ramped up to the respective operating current. The ramping up may be chosen/configured such that the thermal inertia of the respective optical element is compensated.

The step 23 of returning to running the system in operating mode, may comprise reestablishing and/or starting the cooling of the at least one charged particle optics element and/or providing the respective operating current for each of the charged particle optics elements. In other words, when the system is brought back out of the standby mode the cooling is restored and the respective currents provided to the charged particle optics elements are restored to the normal method of driving and the normal application levels. Step 23 may further comprise determining and indicating when the respective element temperature has been stabilized to the respective temperature setpoint. This may for example take at most 1 hour, preferably at most 30 minutes, more preferably at most 10 minutes, such as a few minutes.

In some embodiments, an automatic nightly routine for switching into standby mode and back may be provided, which can be overruled by a user for overworking. This may also be done such that the system is ready, i.e., warmed up and stabilized, by a requested time and thus returned to running in operating mode early enough to account for the time for fully stabilizing in operating mode. In other words, the method may comprise scheduling a standby time for automatically switching the charged particle system form running in the operating mode to running in the standby mode. Furthermore, the method may comprise scheduling an operating time for automatically switching the charged particle system from running in the standby mode to running in the operating mode. Further, scheduling the operating time for automatically switching the charged particle system from running in the standby mode to running in the operating mode may include stabilizing the respective element temperature prior to the scheduled operating time. In other words, after leaving standby mode, the system may warm-up and indicate it is ok only when the temperature of the charged particle optics element (resistance), e.g., coil temperature, has stabilized. This means that after a request to resume normal operation after running in standby mode the temperature of the charged particle optics element, e.g., coil resistance, may be observed and only when it is at the normal operating value (logged before entering standby mode) then the system indicates this to the user.

The disclosed method may be computer-implemented. That is, the method may be performed by a processing unit, computer and/or control unit which performs the method and may thereby control the charged particle system.

Thus, the present invention provides a charged particle system and a method that allow for reduction of the power consumption when the system is in an idle state, i.e., not used by a user, without the downside of multiple hours for stabilizing the system after switching it on. Based Fig. 1a and 1b it is estimated that 4.6 kW power reduction may be saved due to reduced power consumption of the charged particle optics elements and the cooling assembly. When considering an on average operation time, i.e., imaging, of charged particle systems, this may allow for an annual energy consumption reduction of 18-25%.

In other words, about 3-4 kW of heat may be dumped in cooling fluid. Thus, a standby mode is provided, wherein the fluid flow to the at least one charged particle optics element is turned off, while their temperature is maintained by using a desired temperature as setpoint (respective temperature setpoint), e.g., a coil resistance of an electromagnetic lens, and the respective current provided to the at least one charged particle optics element is used as a variable, i.e., controlled. Without the cooling, this will result in a significantly lower current than during operating mode and consequently a power reduction. When returning the particle current system to operating mode, the cooling is reestablished and the provided current is returned to normal current drive, i.e., operating current.

Overall the provided method and system may allow for a standby mode, that provides significant power savings, while still allowing a user to switch back into operating mode without a need for the system to settle down over hours. That is, owing to the method/system stabilizing the temperature charged particle optics element and simultaneously stopping the cooling, stability of the system can be achieved significantly faster when switching back to operating mode, since the system does not need a cold start, but the charged particle optics elements are at least at a temperature close to their operating temperature, preferably at their operating temperature even in standby mode.

Whenever a relative term, such as "about", "substantially" or "approximately" is used in this specification, such a term should also be construed to also include the exact term. That is, e.g., "substantially straight" should be construed to also include "(exactly) straight".

Whenever steps were recited in the above or also in the appended claims, it should be noted that the order in which the steps are recited in this text may be accidental. That is, unless otherwise specified or unless clear to the skilled person, the order in which steps are recited may be accidental. That is, when the present document states, e.g., that a method comprises steps (A) and (B), this does not necessarily mean that step (A) precedes step (B), but it is also possible that step (A) is performed (at least partly) simultaneously with step (B) or that step (B) precedes step (A). Furthermore, when a step (X) is said to precede another step (Z), this does not imply that there is no step between steps (X) and (Z). That is, step (X) preceding step (Z) encompasses the situation that step (X) is performed directly before step (Z), but also the situation that (X) is performed before one or more steps (Y1), ..., followed by step (Z). Corresponding considerations apply when terms like "after" or "before" are used.

While in the above, a preferred embodiment has been described with reference to the accompanying drawings, the skilled person will understand that this embodiment was provided for illustrative purpose only and should by no means be construed to limit the scope of the present invention, which is defined by the claims.

## Claims

1. A method for reducing the power consumption of a charged particle system, the charged particle system comprising at least one charged particle optics element and a cooling assembly configured for cooling the at least one charged particle optics element, the method comprising the steps of
running the charged particle system in a standby mode, wherein the total power consumption of the charged particle system is reduced compared to running the charged particle system in an operating mode.

2. The method according to the preceding claim, wherein each of the at least one charged particle optics element comprises a respective element temperature;
wherein the method further comprises determining a respective temperature setpoint for at least one of the at least one charged particle optics element; and
wherein running the charged particle system in the standby mode comprises
reducing and/or stopping the cooling of said at least one charged particle optics element and
stabilizing the respective element temperature of said at least one charged particle optics element to the respective temperature setpoint.

3. The method according to any of the preceding claims, wherein the at least one charged particle optics element is current driven and the method comprises providing a respective current to each of the at least one charged particle optics element.

4. The method according to the preceding claim and with the features of claim 2,
wherein stabilizing the respective element temperature comprises providing a respective standby current to the associated charged particle optics element, and
wherein providing the respective standby current comprises controlling the respective standby current provided to the associated charged particle optics element.

5. The method according to the preceding claim, wherein controlling the respective standby current provided to the associated charged particle optics element comprises reducing the average current compared to running the charged particle system in the operating mode.

6. The method according to any of claims 4 and 5, wherein stabilizing the respective element temperature of the associated charged particle optics element comprises determining a present element temperature of the associated charged particle optics element, and
wherein controlling the respective standby current comprises comparing the present element temperature of the associated charged particle optics element to the respective temperature setpoint and adjusting the provided respective standby current based on said comparing.

7. The method according to any of claims 5 and 6, wherein controlling the respective standby current provided to the associated charged particle optics element comprises modulating said standby current to reduce the average current supplied to the associated charged particle optics element.

8. The method according to any of the preceding claims, wherein the power consumption of the charged particle system running in the standby mode is reduced by at least 33%, preferably at least 40%, more preferably at least 50% compared to running the charged particle system in the operating mode.

9. The method according to any of the preceding claims, wherein the at least one charged particle optics element is an electromagnetic lens.

10. The method according to any of the preceding claims, wherein the charged particle system is a charged particle beam microscopy system.

11. A charged particle system comprising
at least one charged particle optics element; and
a cooling assembly configured for cooling the at least one charged particle optics element,
wherein the system is configured to assume at least two configurations, an operating configuration and a standby configuration.

12. The charged particle system according to the preceding claim,
wherein the at least one charged particle optics element is current driven;
wherein in the operating configuration each of the at least one charged particle optics element is provided with a respective operating current; and
wherein in the standby configuration at least one of the at least one charged particle optics element is provided with a respective standby current that is at least on average lower than the operating current.

13. The charged particle system according to any of claims 11 to 12,
wherein in the operating configuration each of the at least one charged particle optics element is at a respective operating temperature;
wherein the respective operating temperature defines a respective temperature setpoint for each of the at least one charged particle optics element; and
wherein in the standby configuration at least one of the at least one charged particle optics element is stabilized to the respective temperature setpoint.

14. The charged particle system according to any of claims 11 to 13,
wherein in the operating configuration the at least one charged particle optics element is cooled by means of the cooling assembly; and
wherein in the standby configuration at least one of the at least one charged particle optics element is cooled less or not cooled by means of the cooling assembly.

15. The charged particle system according to any of claims 11 to 14, wherein the system is configured to perform the method according to any of claims 1 to 10.
